# EUROPEAN PATENT SPECIFICATION

(11) **EP 2 674 772 B1**
(45) Date of publication and mention of the grant of the patent: **10.12.2014**
(21) Application number: 13172088.0
(22) Date of filing: 14.06.2013
(51) Int. Cl.: G01R 33/00, G01R 33/10, G01N 27/82

(54) **A system for evaluating ferromagnetic objects and a method therefor**
System zur Bewertung ferromagnetischer Objekte und Verfahren dafür
Système pour évaluer des objets ferromagnétiques et procédé associé

(30) Priority: 15.06.2012 MY PI2012002705
(43) Date of publication of application: 18.12.2013
(73) Proprietor: Universiti Putra Malaysia, 43400 Serdang (MY)
(72) Inventor: Misron, Norhisam, 43400 UPM Serdang, Selangor (MY); Shin, Ng Wei, 43400 UPM Serdang, Selangor (MY); Firdaus, Raja Nor, 43400 UPM Serdang, Selangor (MY)
(74) Representative: Dilg, Haeusler, Schindelmann Patentanwaltsgesellschaft mbH

(56) References cited:
- GB-A- 2 475 314
- US-A- 4 439 730
- US-A- 5 182 513
- US-A- 5 399 968
- US-A1- 2006 111 872
- US-A1- 2011 132 092
- US-A1- 2013 127 452

## Description

### FIELD OF THE INVENTION

The present invention relates to a system for evaluating ferromagnetic objects.

### BACKGROUND ART

The Non Destructive Evaluation (NDE) is a well-known technique used to examine and describe the condition of ferromagnetic materials without causing any damage to them. Some relevant techniques are disclosed in the following documents: US 2006/111872,
US 2011/132092, US 2013/127452, US 4 439 730, US 5 399 968, US 5 182 513, GB 2 475 314.

Besides that, the additional advantage of NDE technique is that it does not introduce health hazards to its operator. As such, the NDE technique is often employed to evaluate the quality and condition of steel water pipe and steel cables embedded underneath walls or floors. The NDE technique employed for evaluation of steel water pipe and steel cables is able to detect cracks and discontinuity within the material which is under evaluation.

The detection principle with NDE is based on the Magnetic Flux Leakage Test (MFLT). The MFLT principle requires the material under evaluation to be temporarily magnetized either with permanent magnets or with electromagnets. As such, the magnetic flux flow is developed between the magnetic source (e.g. permanent magnets or electromagnet) and the ferromagnetic materials under evaluation. The flux flow is detected quantitatively by magnetic sensors exposed to the magnetic flux. As discontinuity or cracks is observed on the ferromagnetic material, the magnetic flux leakage (MFL) perturbs the magnetic flux flow that is detected by the magnetic sensors exposed to it.

The NDE application technique is also widely used in applications such as the evaluation of pulse diagnostics, the proximity sensing, in aircraft structures, in train-wheels, in oil-gap pipe, in power plant, in a chemical plant and in a nuclear plant. The purpose of this NDE technique is to evaluate the quality of the surface under study; thereby providing the necessary maintenance to prevent unwanted occurrence such as fatal accidents in advance.

However, in observation, none of the available NDE testing provides mobile and unmanned control on detection techniques. Most of the sensors are manually inserted around the target plane and detection can be notified through alarm sound. Usually, the evaluation on that detected fault is carried out through manual visual inspection and the absolute signal reading from the sensor. Generally, the bigger the value of the reading signal shows that the detected fault is worse. Thus, the evaluation on the shape and the size of a fault can only be gauged.

In light of the above, it appears that the existing technique in detecting the faults in the ferromagnetic objects is not sufficient. The results that can be obtained through the existing technique are still limited. The operator can usually only obtain the results from reading the signals indicated by light indicators such as blinking LED lights or etc. or alarm sound. Since the faults that ferromagnetic objects come in various size and shape, it is therefore understood that such faults can only be detected or gauged but they are too complicated for accurate measurement. The complexity of these faults therefore makes it difficult for these techniques or devices to, apart from to yield accurate data, to present the data to the operator in an accurate manner.

Furthermore, it is difficult for the detection of the ferromagnetic objects through the NDE technique for imaging the ferromagnetic objects. Usually, to image such ferromagnetic objects, MRI is used. However, comparatively, the MRI is bulkier. On a further note, in the MRI, the imaging is performed by analyzing the frequency of the electromagnetic wave emitted from a transmitter throughout the medium, and the electromagnetic wave therefrom is received by the receiver on the other side.

In light of the above, a system and a method that are able to evaluate the ferromagnetic objects, and sufficient as such are very much in need.

### SUMMARY OF THE INVENTION

According to the present invention, there is provided a system for evaluating ferromagnetic objects according to claim 1.

According to one aspect of the present invention, the system comprises a magnetic sensing unit (50), a magnetic signal acquisition unit (150), and a magnetic signal processing unit.

The magnetic sensing unit (50) comprises a plurality of magnetic-field generating components (20), and a plurality of magnetic-field sensing components (30) that operate with the magnetic-field generating components (20). The magnetic-field generating component (20) is for generating magnetic field. During the evaluation, the ferromagnetic object (10) is adapted to relatively travel under magnetic flux (210) generated by each of the magnetic-field generating components (20) and past the magnetic-field sensing components (30). The magnetic-field sensing component (30) is adapted for detecting the magnetic flux (210) that flows through the ferromagnetic object (10) as magnetic signals (55).

The magnetic signal acquisition unit (150) is adapted for acquiring data with regards the magnetic signals (55) in relation to the magnetic flux (210) detected from the ferromagnetic object (10). The magnetic signal processing unit (250) is adapted for processing and adapting the data in a displayable format.

According to another aspect of the present invention, the present invention relates to a method for evaluating ferromagnetic objects (10) according to claim 8. The method comprises the step: a) generating magnetic field by means of a plurality of magnetic-field generating components (20), wherein a plurality of magnetic-field sensing components (30) are adapted to operate with the magnetic- field generating components (20); b) allowing the ferromagnetic to relatively travel under magnetic flux (210) generated by each of the magnetic-field generating components (20) and past the magnetic-field sensing components (30); c) detecting the magnetic flux (210) that flows through the ferromagnetic object (10) as magnetic signals (55); d) acquiring data with regards the magnetic signals (55) in relation to the magnetic flux (210) detected from the ferromagnetic object (10) by means of a magnetic signal acquisition unit (150); and e) processing and adapting the data in a displayable format by means of a magnetic signal processing unit (250).

It is an object of the present invention to provide a system and a method for evaluating the ferromagnetic objects that are able to read sufficiently and accurately the magnetic signals given by the ferromagnetic objects through the relative arrangements of the magnetic-field generating components and the magnetic-field sensors.

It is further an object of the present invention to provide a system and a method for evaluating the ferromagnetic objects that are able to acquire and analyze the data obtained from the magnetic-field sensors in an accurate manner.

It is also an object of the present invention to provide a system and a method for evaluating the ferromagnetic objects that are able to present the data obtained from the magnetic-field sensors in a clear, accurate, sufficient and comprehensive manner. In other words, the present system and method assist in imaging the results of the detection and evaluation of the ferromagnetic objects.

It is also an object of the present invention to provide a system and a method for evaluating the ferromagnetic objects that are flexible in terms of being adapted into a compact or mobile configuration or in a fixed configuration.

It is also an object of the present invention to provide a system and a method for evaluating the ferromagnetic objects that are cost-effective to be implemented.

It is a final object of the present invention to provide a system and a method for evaluating the ferromagnetic objects that is capable of requiring less or no manual control.

The present invention consists of certain novel features and a combination of parts hereinafter fully described and illustrated in the accompanying drawings and particularly pointed out in the appended claims; it being understood that various changes in the details may be without departing from the scope of the invention or sacrificing any of the advantages of the present invention.

### BRIEF DESCRIPTION OF THE DRAWINGS

For the purpose of facilitating an understanding of the invention, there is illustrated in the accompanying drawings the preferred embodiments from an inspection of which when considered in connection with the following description, the invention, its construction and operation and many of its advantages would be readily understood and appreciated.
FIG. 1 shows the building block of the imaging detection system on a ferromagnetic object using a mobile Hall array.
FIG. 2 shows the block diagram of the hardware modules for the hall sensor array system.
FIG. 3 shows how the 1-Dimensional (1-D) Hall sensor array detects the magnetic flux leakage caused by the magnetized ferrous object.
FIG. 4(a) shows the top view of the frame array which constructs the 1-D hall sensor array by linearly integrating 33 SS496A solid state Hall effects sensors.
FIG. 4(b) shows the placement of 1-D Hall sensor array with the magnet A and B.
FIG. 5 shows the connection of the output from the 1-D Hall sensor array to the analog multiplexer circuit and then to A/D conversion channels of AT90USB646 microcontroller.
FIG. 6(a) shows the algorithm to construct the processed 1-D Hall sensor array signals from the USB communication.
FIG. 6(b) shows the algorithm for 2-Dimensional (2-D) array matrix construction from the 1-D Hall sensor array signals.

### DETAILED DESCRIPTION OF THE PREFERRED EMBODIMENTS

The present invention relates to a system (100) and a method for evaluating ferromagnetic objects. Hereinafter, the system (100) and the method shall be described according to the preferred embodiments of the present invention and by referring to the accompanying description and drawings. However, it is to be understood that limiting the description to the preferred embodiments of the invention and to the drawings is merely to facilitate discussion of the present invention and it is envisioned that those skilled in the art may devise various modifications without departing from the scope of the appended claim.

The present system (100) and system is related to an imaging detection system or method on ferromagnetic part (10) for example using a mobile hall array that is embedded underneath the walls or floors. This kind of invention is applicable for various fields of non-destructive testing area that detects faults on the ferromagnetic part (10) such as in factory, manufacturing, and oil and gas.

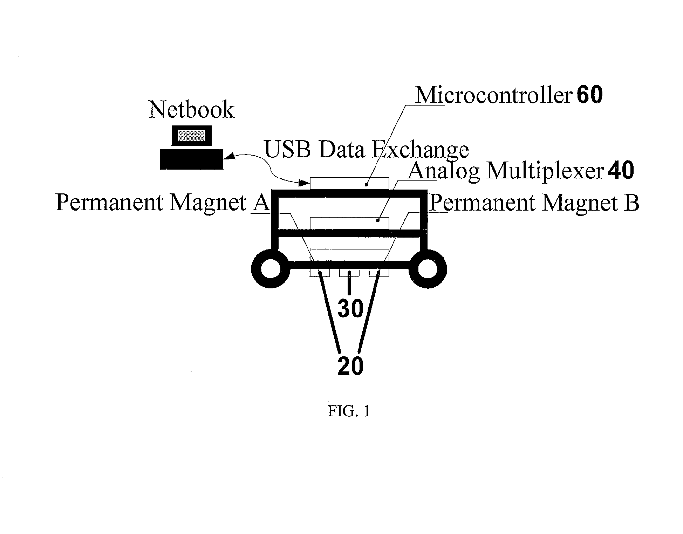

Referring to FIG. 1-6, according to the first aspect of the present invention, the system (100) comprises a magnetic sensing unit (50), a magnetic signal acquisition unit (150), and a magnetic signal processing unit (250).

Referring particularly to FIG. 1, 3, and 4(b), the magnetic sensing unit (50) comprises a plurality of magnetic-field generating components (20), and a plurality of magnetic-field sensing components (30) that operate with the magnetic-field generating components (20).

The magnetic-field generating component (20) is adapted for generating magnetic field. During the evaluation, the ferromagnetic object (10) is adapted to relatively travel under magnetic flux (210) generated by each of the magnetic-field generating components (20) and past the magnetic-field sensing components (30). The magnetic-field sensing component (30) is adapted for detecting the magnetic flux (210) that flows through the ferromagnetic object (10) as magnetic signals (55);

The magnetic signal acquisition unit (150) is adapted for acquiring data with regards the magnetic signals (55) in relation to the magnetic flux (210) detected from the ferromagnetic object (10). The magnetic signal processing unit (250) is adapted for processing and adapting the data in a displayable format.

Referring to FIG. 1, 3 & 4(b), without the presence of the ferromagnetic object (10) in the system (100), the magnetic flux (210) generated by the magnetic-field generating components (20) does not flow in a pattern that is detectable by the magnetic-field sensing components (30). However, in the presence of the ferromagnetic object (10) in the vicinity of the magnetic-field generating components (20), the magnetic flux (210) flows through the ferromagnetic object (10) and the magnetic flux leakage (MFL) (220) is generated. The MFL (220) flows in a pattern that is detectable by the magnetic-field sensing components (30).

The magnetic-field sensing components (30) are flanked or surrounded by the magnetic-field generating components (20). The magnetic flux (210) generated by the magnetic-field generating components (20) on either side of or around the magnetic-field sensing components (30) flows in an opposite direction to each other. The MFL (220) detected by the magnetic-field sensing components (30) that flows in a first direction yields a positive magnetic signal (55), whereas the MFL (220) detected by the magnetic-field sensing components (30) that flows in a second direction yields a negative magnetic signal (55). The first and second directions are in the opposite direction to each other. The magnetic-field sensing components (30) measure the MFL (220) in terms of a magnetic-field leakage density value, or any other value suitable to determine the amount of the MFL (220).

When the ferromagnetic object (10) is in the vicinity of the magnetic-field generating component (20), the closer the ferromagnetic object (10) gets to the magnetic-field sensing components (30), the relatively higher the MFL density values is, whereas the further the ferromagnetic object (10) gets to the magnetic-field sensing components (30), the relatively lower the MFL density value is.

The magnetic-field generating components (20) on either side of or around the magnetic-field sensing components (30) generate the same density of the magnetic flux (210). When the ferromagnetic object (10) travels to the center of the magnetic-field sensing components (30), both MFL (220) from either side of or the MFL (220) around the magnetic-field sensing components (30) are detected by the magnetic-field sensing components (30).

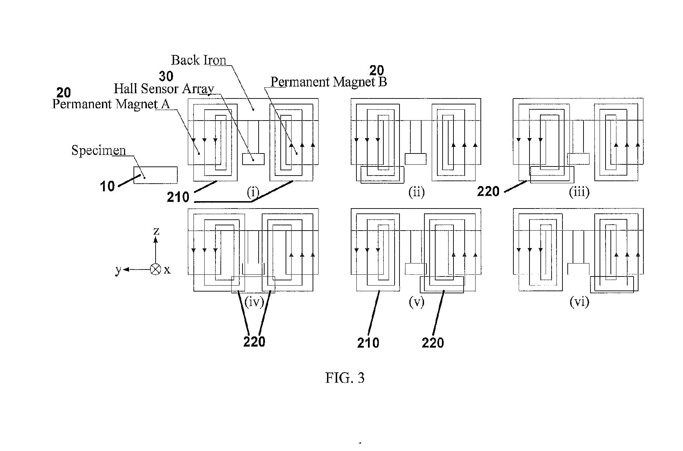

Referring still to FIG. 3, when the ferromagnetic object (10) travels to the center of the magnetic-field sensing component, due to the same density of the magnetic flux (210) flowing in the opposite directions from both side of or around the magnetic-field sensing components (30), the MFL (220) from both sides of or around the magnetic-field sensing components (30) are of the same density and the MFL (220) from the both sides or around thereof cancels each other yielding no magnetic signals (55) for the magnetic-field sensing components (30) i.e. no MFL density value.

Referring to FIG. 3 again, the first and second directions of the MFL (220) detected by the magnetic-field sensing components (30) respectively are an upward and a downward directions.

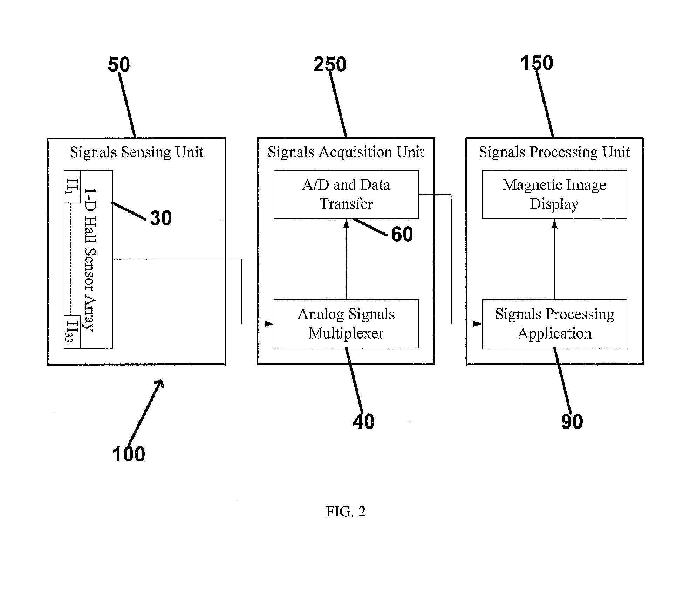

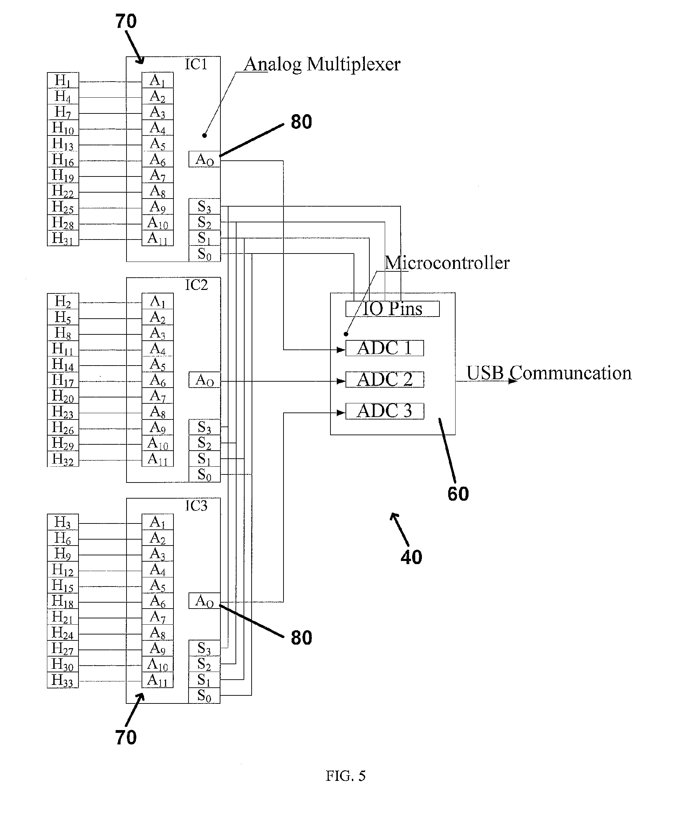

Referring to FIG. 2 & 5, the magnetic signal acquisition unit (150) comprises a plurality of input selector components (40), and a magnetic signal digitalizing component (60). The input selector component (40) comprises a plurality of input channels (70) and an output (80). The input selector component (40) is adapted for receiving the magnetic signal (55) from the magnetic-field sensing components (30). The magnetic signal digitalizing component (60) is adapted for instructing the input selector components (40) to select one of the input channels (70) to receive a number of the magnetic signals (55) selectively in batches from the magnetic-field sensing components (30), for converting the magnetic signals (55) into digital signals (57), and for forwarding the digital signals (57) to the magnetic signal processing unit (250).

After the preceding batch of the magnetic signals (55) has been digitalized into the digital signals (57), the magnetic signal digitalizing component (60) is further adapted for continuing to instruct the input selector components (40) to select the next input channel (70) to receive the next batch of the magnetic signals (55) from the magnetic-field sensing components (30), for converting the magnetic signals (55) into the digital signals (57), and for forwarding the digital signals (57) to the magnetic signal processing unit (250).

According to the instructions of the magnetic signal digitalizing component (60), the input selector components (40) continue to select the next input channel (70) to receive the succeeding batch of the magnetic signals (55), convert the magnetic signals (55) to the digital signals (57), and forward the digital signals (57) to the magnetic signal processing unit (250) till the last batch of the magnetic signals (55). Once the input selector components (40) reach the final batch of the magnetic signals (55), the magnetic field digitalizing component (60) resets its instruction to the first batch of another set of the magnetic signals (55).

The magnetic-field sensing components (30) convert the detected MFL (220) into the magnetic signals (55) i.e. voltage signals, V_{H} at the output thereof.

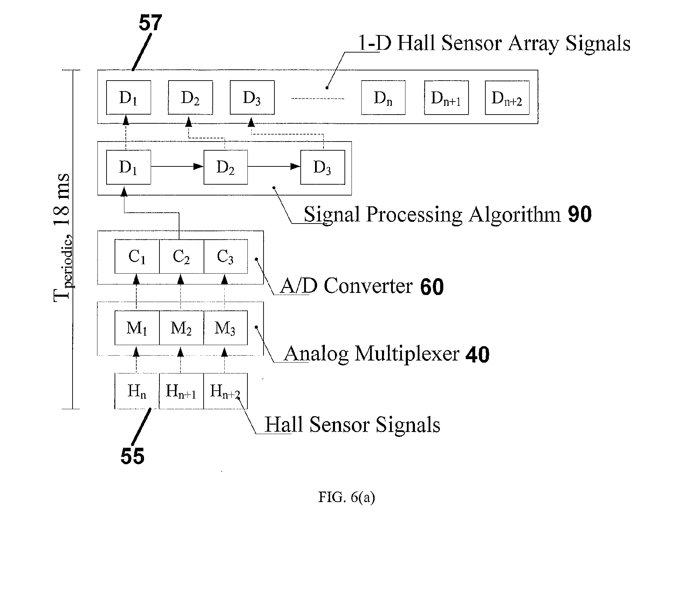

Referring to FIG. 2 & 6(a), the magnetic-field processing unit (250) comprises a magnetic-field processing component (90). The magnetic-field processing component (90) is adapted for processing the digital signals (57) in batches, and for appending the processed digital signals into a matrix format.

The magnetic-field processing component (90) is further adapted for repeating processing the batches of the digital signals (57) and appending the digital signals (57) into the matrix format till all of the digital signals (57) are processed.

The processed digital signals (57) are appended into a one-dimensional matrix format. The magnetic-field processing component (90) is further adapted for constructing a two-dimensional matrix format (59). The digital signals (57) are continuously appended to the two-dimensional matrix format (59) as the magnetic-field processing component (90) continues to navigate through all the digital signals (57).

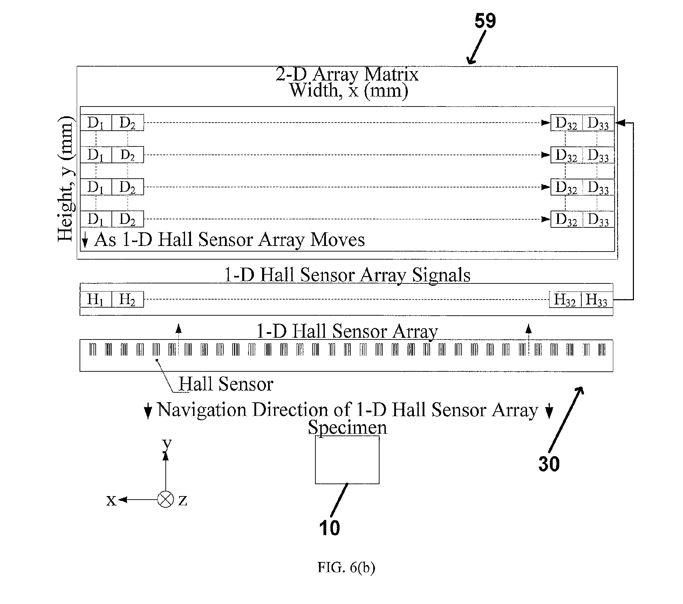

Referring now to FIG. 6(a) & (b), the digital signals (57) appended to the two-dimensional matrix format (59) i.e. in a two-dimensional array matrix (59) are used for imaging or visualization of a magnetic image of the ferromagnetic object (10).

Referring to FIG. 1-6, according to another aspect of the present invention, the present invention is also related to a method for evaluating ferromagnetic objects (10). The method comprises the steps of:
f) generating magnetic field by means of a plurality of magnetic-field generating components (20), wherein a plurality of magnetic-field sensing components (30) are adapted to operate with the magnetic-field generating components (20);
g) allowing the ferromagnetic to relatively travel under magnetic flux (210) generated by each of the magnetic-field generating components (20) and past the magnetic-field sensing components (30);
h) detecting the magnetic flux (210) that flows through the ferromagnetic object (10) as magnetic signals (55);
i) acquiring data with regards the magnetic signals (55) in relation to the magnetic flux (210) detected from the ferromagnetic object (10) by means of a magnetic signal acquisition unit (150); and
j) processing and adapting the data in a displayable format by means of a magnetic signal processing unit (250).

Referring to FIG. 3, without the presence of the ferromagnetic object (10), the magnetic flux (210) generated by the magnetic-field generating components (20) does not flow in a pattern that is detectable by the magnetic-field sensing components (30). However, in the presence of the ferromagnetic object (10) in the vicinity of the magnetic-field generating components (20), the magnetic flux (210) flows through the ferromagnetic object (10) and the magnetic flux leakage (MFL) (220) is generated. The MFL (220) flows in a pattern that is detectable by the magnetic-field sensing components (30).

Referring to FIG. 1, 3 & 4(b), the magnetic-field sensing components (30) are flanked or surrounded by the magnetic-field generating components (20). The magnetic flux (210) generated by the magnetic-field generating components (20) on either side of or around the magnetic-field sensing components (30) flows in an opposite direction to each other as shown in FIG. 3. The MFL (220) detected by the magnetic-field sensing components (30) that flows in a first direction yields a positive magnetic signal (55), whereas the MFL (220) detected by the magnetic-field sensing components (30) that flows in a second direction yields a negative magnetic signal (55). The first and second directions are in the opposite direction to each other. The magnetic-field sensing components (30) measure the MFL (220) in terms of a magnetic-field leakage density value.

Referring to FIG. 3, when the ferromagnetic object (10) is in the vicinity of the magnetic-field generating component (20), the closer the ferromagnetic object (10) gets to the magnetic-field sensing components (30), the relatively higher the MFL density values is, whereas the further the ferromagnetic object (10) gets to the magnetic-field sensing components (30), the relatively lower the MFL density value is.

Referring still to FIG. 3, the magnetic-field generating components (20) on either side of or around the magnetic-field sensing components (30) generate the same density of the magnetic flux (210). When the ferromagnetic object (10) travels to the center of the magnetic-field sensing components (30), both MFL (220) from either side of or the MFL (220) around the magnetic-field sensing components (30) are detected by the magnetic-field sensing components (30).

When the ferromagnetic object (10) travels to the center of the magnetic-field sensing component (30), due to the same density of the magnetic flux (210) flowing in the opposite directions from both side of or around the magnetic-field sensing components (30), the MFL (220) from both sides of or around the magnetic-field sensing components (30) are of the same density and the MFL (220) from the both sides or around thereof cancels each other yielding no magnetic signals (55) for the magnetic-field sensing components (30) i.e. no MFL density value as shown in FIG. 3.

The first and second directions of the MFL (220) detected by the magnetic-field sensing components (30) respectively are an upward and a downward directions as shown in FIG. 3.

Referring to FIG. 5, the magnetic signal acquisition unit (150) comprises a plurality of input selector components (40), and a magnetic signal digitalizing component (60). The input selector component (40) comprises a plurality of input channels (70) and an output (80). The above-mentioned step (d) of acquiring data with regards the magnetic signals (55) comprises the following steps of:
i) receiving the magnetic signal (55) from the magnetic-field sensing components (30) by means of the input selector component (40);
ii) instructing the input selector components (40) by means of the magnetic signal digitalizing component (60) to select one of the input channels (70) to receive a number of the magnetic signals (55) selectively in batches from the magnetic-field sensing components (30) by means of the input selector component (40);
iii) converting the magnetic signals (55) into digital signals (57) by means of the input selector component (40); and
iv) forwarding the digital signals (57) to the magnetic signal processing unit (250) by means of the input selector component (40).

Referring still to FIG. 5, the above mentioned step (d) of acquiring data with regards the magnetic signals (55) of Claim 1 further comprises the following steps of:
i) after the preceding batch of the magnetic signals (55) has been digitalized into the digital signals (57), continuing to instruct the input selector components (40) by means of the magnetic signal digitalizing component (60) to select the next input channel (70) to receive the next batch of the magnetic signals (55) from the magnetic-field sensing components (30) by means of the input selector component (40);
ii) converting the magnetic signals (55) into the digital signals (57) by means of the input selector component (40); and
iii) forwarding the digital signals (57) to the magnetic signal processing unit (250) by means of the input selector component (40).

Referring again to FIG. 5, the above-mentioned step (d) of acquiring data with regards the magnetic signals (55) further comprises the following steps of:
i) according to the instructions of the magnetic signal digitalizing component (60), continuing to select the next input channel (70) to receive the succeeding batch of the magnetic signals (55) into the digital signals (57) by means of the input selector components (40);
ii) converting the magnetic signals (55) to the digital signals (57) by means of the input selector components (40);
iii) forwarding the digital signals (57) to the magnetic signal processing unit (250) till the last batch of the magnetic signals (55) by means of the input selector components (40); and
iv) once the input selector components (40) reach the final batch of the magnetic signals (55), resetting the instructions to the first batch of another set of the magnetic signals (55) by means of the magnet signal digitalizing component (60).

The magnetic-field sensing components (30) convert the detected MFL (220) into the magnetic signals (55) i.e. voltage signals, V_{H} at the output thereof.

The magnetic-field processing unit (250) comprises a magnetic-field processing component (90). Referring to FIG. 6(a) & (b), the above-mentioned step (e) of processing and adapting the data in a displayable format of Claim 1 comprises the step of:
i) processing the digital signals (57) in batches, and
ii) appending the processed digital signals into a matrix format by means of the magnetic-field processing component (90).

Referring to FIG. 6(a) & (b), the above-mentioned step (e) of processing and adapting the data in a displayable format further comprises the step of:
i) repeating processing the batches of the digital signals (57); and
ii) appending the digital signals (57) into the matrix format till all of the digital signals (57)

are processed by means of the magnetic-field processing component (90).

The above-mentioned step (e) of processing and adapting the data in a displayable format further comprises the step of:
i) constructing a two-dimensional matrix format (59) by means of the magnetic-field processing component (90);

The processed digital signals (57) are appended into a one-dimensional matrix format. The digital signals (57) is continuously appended to the two-dimensional matrix format (59) as the magnetic-field processing component (90) continues to navigate through all the digital signals (57).

The digital signals (57) appended to the two-dimensional matrix format (59) i.e. in a two-dimensional array matrix (59) are used for imaging or visualization of a magnetic image of the ferromagnetic object (10).

In light of the above, as an example, the system (100) and the method of the present invention are further hereinafter described in greater details.

As an example, the present system (100) comprises several modules that build the imaging detection system on ferromagnetic part (10) using a mobile hall array. As mentioned above, these modules are encompassed with the signals sensing unit (50), signals acquisition unit (150) and signals processing unit (250). The data path of these modules determines the signal sensing and processing flow of the imaging detection system (100) on the ferromagnetic part (10).

The magnetic sensing unit (50) or the signals sensing unit (50) comprises both permanent magnets A and B (20) linearly integrating 33 SS496A Solid State Hall Effect Sensors (30) into 1-D Hall sensor array. The permanent magnets A and B (20) are used to magnetize the ferrous objects (10) under evaluation. The magnetic flux leakage (MFL) (220) from the magnetized ferrous objects (10) is detected by the 1-D Hall sensor array (30).

The magnetic signal acquisition unit (150) or the signal acquisition unit (150) comprises the electronic circuits of analog multiplexers (40) and an AT90USB646 microcontroller (60). The 3 analog multiplexers (40) are used to channel the 33 signals from linearly integrated 1-D Hall sensor array (30) to 3 A/D channels of AT90USB646 microcontroller. As the digitization of Hall sensor signals completed, the AT90USB646 microcontroller transfers the digitized data signals to the computer for signal processing through USB communication protocol.

The magnetic signal processing unit (250) or the signals processing unit (250) is a computer or other electrical or electronic medium loaded with the Hall Sensor Array Processing application (90) for Hall sensor signals processing and 2-D array matrix construction. The Hall Sensor Array Processing application (90) integrates the algorithm to distinguish the induced Hall voltage signals of 1-D Hall sensor array (30) caused by the permanent magnet A and B (20). Besides, this application (90) also encompasses the algorithm used to construct the 2-D array matrix of induced signals for magnetic imaging.

FIG. 1 relates to the building block of the imaging detection system (100) on ferromagnetic part (10) using a mobile hall array. The system (100) consists of the permanent magnet A and B (20), 1-D Hall sensor array (30), an analog multiplexers circuit (40), a microcontroller (60) as well as a computer (netbook or etc.).

FIG. 2 relates to the block diagram of hardware modules for Hall Sensor Array System. The hardware modules comprises a signals sensing unit (50), a signals acquisition unit (150) and a signals processing unit (250). The signals sensing unit (50) comprises permanent magnets A and B (20) with the 1-D Hall sensor array (30). The 1-D Hall sensor array (30) comprises 33 linearly integrated SS496A Solid State Hall Effects sensor (30) with output signals of H₁ to H₃₃. The 1-D Hall sensor array (30) is responsible for the detection of the magnetic flux (210) flow on the ferrous object (10) under evaluation. The signals acquisition unit (150) comprises the analog multiplexer circuit (40) and the microcontroller (50). The analog multiplexer circuit (40) is responsible to channel the output signals H₁ to H₃₃ from 1-D Hall sensor array (30) to the 3 A/D conversion channels of the microcontroller (40). The digitized 1-D Hall sensor signals (57) from the microcontroller (60) are then sent to the computer (netbook) through the USB data communication. Lastly, the signals processing unit (250) comprises the computer (netbook) with Hall Sensor Signal Array Application (90). The Hall Sensor Signal Array application (90) consists of the algorithm to arrange the 1-D Hall sensor array signals (57) to 2-D array matrix for magnetic image construction of the ferrous object (10) under evaluation.

FIG. 3 explains the principle for the 1-D Hall sensor array (30) in detecting magnetic flux leakage (MFL) (220) caused by the magnetized ferrous specimen (10). During normal condition of the 1-D Hall sensor array (30), the magnetic flux (210) flow is as shown in (i). As the specimen (10) navigates along the y-axis, the magnetic leakage flux (MFL) (220) is developed and the MFL (220) flows within the specimen (10) as shown in (ii). As the specimen (10) approaches the 1-D Hall sensor array (30) shown in (iii), the MFL (220) is detected by the 1-D Hall sensor array. At this moment, the positive signals are produced by the Hall sensor due the MLF flow in upward direction within the permanent magnet A. The higher MFL density values are detected as the specimen gets closer to the Hall sensor. As specimen at the center of the 1-D Hall sensor array in (iv), both MFL (220) flow from permanent magnet A and B are detected by the 1-D Hall sensor array. However, due to the same MFL density flow in opposite directions, the signals cancelled each other. Thus, no induced signals developed by the 1-D Hall sensor array. As the specimen continues to navigate along the y-axis in (v), the MFL (220) flows in downward direction within the permanent magnet B is detected by the 1-D Hall sensor array. At this moment, the negative signals are produced by the Hall sensor due the MLF (220) flowing in downward direction. As specimen deviates from 1-D Hall sensor array in (vi), there are no MFL (220) flow detected, thus, no induced signals developed by the 1-D Hall sensor array. The induced MFL (220) signals on the magnetized ferrous objects create the new path for magnetic flux flow through the permanent magnet A and B. The MFL (220) signals are detected by the 1-D Hall sensor array exposed to it. The density of MFL (220) signals causes by the ferrous specimen differs with the absent of ferrous specimens. With this, the MFL (220) detected by 1-D Hall sensor array are translated to induced voltage signals, V_{H} at the output of linearly integrated 1-D Hall sensor array.

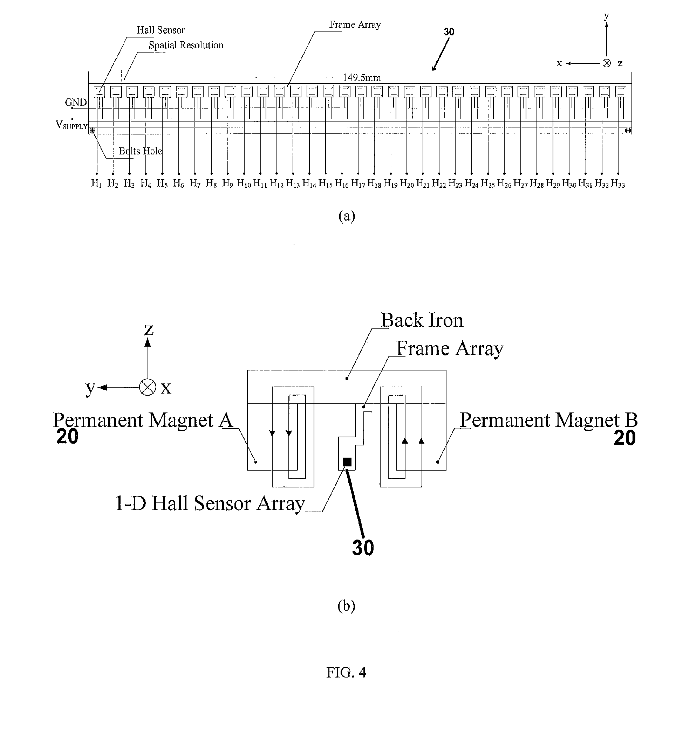

FIG. 4(a) illustrates the top view of frame array which constructs the 1-D Hall sensor array (30) by linearly integrating 33 SS496A solid state Hall effects sensors (30). For example, the spatial resolutions, *xₛ* between Hall effects sensors (30) for this particular design of the mobile magnetic imaging System (100) is given by 0.5mm. The entire width of the frame array is given by 149.5mm. FIG. 4(b) illustrates the placement of 1-D Hall sensor array (30) together with permanent magnet A and B (20) on the back iron. During evaluation of the ferrous object (10), the 1-D Hall sensor array (30) is moved in the direction parallel with the y-axis as illustrated in FIG. 3.

FIG. 5 explains about the connection of the output from 1-D Hall sensor array (30) to analog multiplexer circuit (40) and then to the A/D conversion channels of AT90USB646 microcontroller (60). In FIG. 5, three analog multiplexers (40) are employed. As a start, the general purpose IO pins from the microcontroller (60) are used to drive the three analog multiplexer (40) to select channel A₁, to output three Hall sensor signals namely Hₙ, Hₙ₊₁ and Hₙ₊₂ to A/D converter (60) for digitization. The A/D converter (60) in the microcontroller (60) digitizes the signals, Hₙ, Hₙ₊₁ and Hₙ₊₂ one by one from the ADC 1 to the ADC 3. As the A/D conversion of signals is completed, the digitized signals namely Dₙ, Dₙ₊₁ and Dₙ₊₂ are adapted into a USB data packet format which is forwarded to for example, a computer through a USB communication. As the data packet is forwarded, the microcontroller (60) changes the output signals of the IO pins to select the channel A₂ of three analog multiplexers (40). The above process would continue until the A₁₁ of the three analog multiplexers (40) are selected. As the analog multiplexer (40) reaches the channel A₁₁, the general purpose IO pins from the microcontroller (60) is reset back to A₁.

FIG. 6(a) explains the algorithm to construct the processed 1-D Hall sensor array signals (50) from the USB communication. The analog signals (55) from 1-D Hall sensor array (30) is digitized by the signals acquisition unit (150). At every instant, 3 Hall sensor signals (55) are channeled to the A/D converter C₁, C₂ and C₃ (60) for digitization through the analog multiplexer, M₁, M₂ and M₃ (40) as illustrated in FIG. 6(a). Instantaneously, the 3 digitized Hall sensor signals, Hₙ to Hₙ₊₂ (55) are transferred to the signals processing algorithm resided in signals processing application (90) through USB communication. The 3 Hall sensor signals (55) processing started with H₁, H₂ and H₃ up to H₃₁, H₃₂ and H₃₃. The signal processing algorithm (90) processes every 3 subsequence Hall sensor signals (55) one by one. For instance, the Hₙ is the first being processed to D₁ followed by Hₙ₊₁ to D₂. Lastly, the Hₙ₊₂ is processed to D₃. Once D₁ is processed, it is appended to the 1-D array matrix. Similar goes to D₂ and D₃. This whole process takes about 18ms to complete. The operation mentioned above is repeated until the entire 33 signals (55) from 1-D Hall sensor array (30) are processed. It takes 200ms to completely process the entire 1-D Hall sensor array signals (55).

FIG. 6(b) illustrates the algorithm for 2-D array matrix (59) construction from the 1-D Hall sensor array signals (55) mentioned in FIG. 6(a). The 1-D Hall sensor array signals (55) are continuously appended to the 2-D array matrix (59) in every 200ms as the 1-D Hall sensor array (30) navigates along the y-axis shown in FIG. 6(b). As the navigation of the specimens (10) is completed, the 2-D array matrix (59) is formed in a text file which would be employed in the visualization of specimen's magnetic image.

While in the foregoing specification this invention has been described in relation to certain preferred embodiments thereof and many details have been set forth for purpose of illustration, it will be apparent to those skilled in the art that the invention is susceptible to additional embodiments and that certain of the details described herein can be varied considerably without departing from the basic principles of the invention as defined in the appended claims.

## Claims

1. A system (100) for evaluating ferromagnetic objects (10) comprising:
a magnetic sensing unit (50) having a plurality of magnetic-field generating components (20), and a plurality of magnetic-field sensing components (30) arranged such that they operate with the magnetic-field generating components (20); wherein the magnetic-field generating component (20) is for generating magnetic field; during the evaluation, the ferromagnetic object (10) is adapted to relatively travel under magnetic flux (210) generated by each of the magnetic-field generating components (20) and to travel past the magnetic-field sensing components (30); the magnetic-field sensing component (30) is for detecting the magnetic flux (210) that flows through the ferromagnetic object (10) as magnetic signals (55);
a magnetic signal acquisition unit (150) for acquiring data with regards to the magnetic signals (55) in relation to the magnetic flux (210) detected from the ferromagnetic object (10); and
a magnetic signal processing unit (250) for processing and adapting the data in a displayable format,
wherein the magnetic-field sensing components (30) are flanked or surrounded by the magnetic-field generating components (20) which are arranged such that the magnetic flux (210) generated by the magnetic-field generating components (20) on either side of or around the magnetic-field sensing components (30) flows in an opposite direction to each other; the magnetic flux leakage, MFL, (220) detected by the magnetic-field sensing components (30) that flows in a first direction yields a positive magnetic signal (55), whereas the MFL (220) detected by the magnetic-field sensing components (30) that flows in a second direction yields a negative magnetic signal (55); the first and second directions are in the opposite direction to each other; and the magnetic-field sensing components (30) measure the MFL (220) in terms of a magnetic-field leakage density value.

2. A system (100) as claimed in Claim 1 wherein the system (100) is arranged such that without the presence of the ferromagnetic object (10) in the system (100), the magnetic flux (210) generated by the magnetic-field generating components (20) does not flow in a pattern that is detectable by the magnetic-field sensing components (30); in the presence of the ferromagnetic object (10) in the vicinity of the magnetic-field generating components (20), the magnetic flux (210) flows through the ferromagnetic object (10) and the magnetic flux leakage, MFL, (220) is generated; and the MFL (220) flows in a pattern that is detectable by the magnetic-field sensing components (30), wherein in particular the magnetic-field sensing components (30) convert the detected MFL (220) into the magnetic signals (55) in form of voltage signals V_{H} at the output thereof.

3. A system (100) as claimed in any one of the Claims 1 to 2 wherein the first and second directions of the MFL (220) detected by the magnetic-field sensing components (30) respectively are an upward and a downward directions.

4. A system (100) as claimed in any one of the Claims 1 to 3 wherein the system (100) is arranged such that when the ferromagnetic object (10) is in the vicinity of the magnetic-field generating component (20), the closer the ferromagnetic object (10) gets to the magnetic-field sensing components (30), the relatively higher the MFL density values is, whereas the further the ferromagnetic object (10) gets to the magnetic-field sensing components (30), the relatively lower the MFL density value is, and/or
wherein the system (100) is arranged such that the magnetic-field generating components (20) on either side of or around the magnetic-field sensing components (30) generate the same density of the magnetic flux (210) and arranged such that when
the ferromagnetic object (10) travels to the center of the magnetic-field sensing components (30), both MFL (220) from either side of or the MFL (220) around the magnetic-field sensing components (30) are detected by the magnetic-field sensing components (30), and/or
wherein the system (100) is arranged such that when the ferromagnetic object (10) travels to the center of the magnetic-field sensing component (30), due to the same density of the magnetic flux (210) flowing in the opposite directions from both side of or around the magnetic-field sensing components (30), the MFL (220) from both sides of or around the magnetic-field sensing components (30) are of the same density and the MFL (220) from the both sides or around thereof cancels each other yielding no magnetic signals (55) for the magnetic-field sensing components (30) i.e. no MFL density value.

5. A system (100) as claimed in any one of the Claims 1 to 4 wherein the system (100) is arranged such that the magnetic signal acquisition unit (150) comprises a plurality of input selector components (40), and a magnetic signal digitalizing component (60); the input selector component (40) comprises a plurality of input channels (70) and an output (80); the input selector component (40) is for receiving the magnetic signal (55) from the magnetic-field sensing components (30); the magnetic signal digitalizing component (60) is for instructing the input selector components (40) to select one of the input channels (70) to receive a number of the magnetic signals (55) selectively in batches from the magnetic-field sensing components (30), for converting the magnetic signals (55) into digital signals (57), and for forwarding the digital signals (57) to the magnetic signal processing unit (250),
wherein in particular after the preceding batch of the magnetic signals (55) has been digitalized into the digital signals (57), the magnetic signal digitalizing component (60) is further for continuing to instruct the input selector components (40) to select the next input channel (70) to receive the next batch of the magnetic signals (55) from the magnetic-field sensing components (30), for converting the magnetic signals (55) into the digital signals (57), and for forwarding the digital signals (57) to the magnetic signal processing unit (250).

6. A system (100) as claimed in Claim 5 wherein the system (100) is arranged such that according to the instructions of the magnetic signal digitalizing component (60), the input selector components (40) continue to select the next input channel (70) to receive the succeeding batch of the magnetic signals (55); convert the magnetic signals (55) to the digital signals (57), and forward the digital signals (57) to the magnetic signal processing unit (250) till the last batch of the magnetic signals (55); and once the input selector components (40) reach the final batch of the magnetic signals (55), the magnetic field digitalizing component (60) resets its instruction to the first batch of another set of the magnetic signals (55).

7. A system (100) as claimed in any one of the Claims 1 to 5 wherein the system (100) is arranged such that the magnetic signal processing unit (250) comprises a magnetic-field processing component (90); the magnetic-field processing component (90) is for processing the digital signals (57) in batches, and for appending the processed digital signals into a matrix format,
wherein in particular the magnetic-field processing component (90) is further for repeating processing the batches of the digital signals (57) and appending the digital signals (57) into the matrix format till all of the digital signals (57) are processed,
wherein in particular the processed digital signals (57) are appended into a one-dimensional matrix format; the magnetic-field processing component (90) is further for constructing a two-dimensional matrix format (59); and the digital signals (57) are continuously appended to the two-dimensional matrix format (59) as the magnetic-field processing component (90) continues to navigate through all the digital signals (57),
wherein in particular the digital signals (57) appended to the two-dimensional matrix format (59) in a two-dimensional array matrix (59) are used for imaging or visualization of a magnetic image of the ferromagnetic object (10).

8. A method for evaluating ferromagnetic objects (10) comprising the steps of:
a) generating magnetic field by means of a plurality of magnetic-field generating components (20), wherein a plurality of magnetic-field sensing components (30) are adapted to operate with the magnetic-field generating components (20);
b) allowing the ferromagnetic objects to relatively travel under magnetic flux (210) generated by each of the magnetic-field generating components (20) and to travel past the magnetic-field sensing components (30);
c) detecting the magnetic flux (210) that flows through the ferromagnetic object (10) as magnetic signals (55) by means of magnetic-field sensing components, wherein the magnetic flux on either side of or around the magnetic-field sensing components (30) flows in an opposite direction to each other;
d) acquiring data with regards to the magnetic signals (55) in relation to the magnetic flux (210) detected from the ferromagnetic object (10) by means of a magnetic signal acquisition unit (150); and
e) processing and adapting the data in a displayable format by means of a magnetic signal processing unit (250).

9. A method as claimed in Claim 8 wherein without the presence of the ferromagnetic object (10), the magnetic flux (210) generated by the magnetic-field generating components (20) does not flow in a pattern that is detectable by the magnetic-field sensing components (30); in the presence of the ferromagnetic object (10) in the vicinity of the magnetic-field generating components (20), the magnetic flux (210) flows through the ferromagnetic object (10) and the magnetic flux leakage , MFL, (220) is generated; and the MFL (220) flows in a pattern that is detectable by the magnetic-field sensing components (30), wherein in particular the magnetic-field sensing components (30) convert the detected MFL (220) into the magnetic signals (55) in Form of voltage signals, V_{H} at the output thereof.

10. A method as claimed in any one of the Claims 8 to 9 wherein the magnetic-field sensing components (30) are flanked or surrounded by the magnetic-field generating components (20); the magnetic flux (210) generated by the magnetic-field generating components (20) on either side of or around the magnetic-field sensing components (30) flows in an opposite direction to each other; the MFL (220) detected by the magnetic-field sensing components (30) that flows in a first direction yields a positive magnetic signal (55), whereas the MFL (220) detected by the magnetic-field sensing components (30) that flows in a second direction yields a negative magnetic signal (55); the first and second directions are in the opposite direction to each other; and the magnetic-field sensing components (30) measure the MFL (220) in terms of a magnetic-field leakage density value, wherein in particular the first and second directions of the MFL (220) detected by the magnetic-field sensing components (30) respectively are an upward and a downward directions.

11. A method as claimed in any one of the Claims 8 to 10 wherein when the ferromagnetic object (10) is in the vicinity of the magnetic-field generating component (20), the closer the ferromagnetic object (10) gets to the magnetic-field sensing components (30), the relatively higher the MFL density values is, whereas the further the ferromagnetic object (10) gets to the magnetic-field sensing components (30), the relatively lower the MFL density value is, and/or wherein the magnetic-field generating components (20) on either side of or around the magnetic-field sensing components (30) generate the same density of the magnetic flux (210); when the ferromagnetic object (10) travels to the center of the magnetic-field sensing components (30), both MFL (220) from either side of or the MFL (220) around the magnetic-field sensing components (30) are detected by the magnetic-field sensing components (30), and/or
wherein when the ferromagnetic object (10) travels to the center of the magnetic-field sensing component (30), due to the same density of the magnetic flux (210) flowing in the opposite directions from both side of or around the magnetic-field sensing components (30), the MFL (220) from both sides of or around the magnetic-field sensing components (30) are of the same density and the MFL (220) from the both sides or around thereof cancels each other yielding no magnetic signals (55) for the magnetic-field sensing components (30) i.e. no MFL density value.

12. A method as claimed in any one of the Claims 8 to 11 wherein the magnetic signal acquisition unit (150) comprises a plurality of input selector components (40), and a magnetic signal digitalizing component (60); the input selector component (40) comprises a plurality of input channels (70) and an output (80); the step (d) of acquiring data with regards to the magnetic signals (55) of Claim 8 comprises the steps of:
i) receiving the magnetic signal (55) from the magnetic-field sensing components (30) by means of the input selector component (40);
ii) instructing the input selector components (40) by means of the magnetic signal digitalizing component (60) to select one of the input channels (70) to receive a number of the magnetic signals (55) selectively in batches from the magnetic-field sensing components (30) by means of the input selector component (40);
iii) converting the magnetic signals (55) into digital signals (57) by means of the input selector component (40); and
iv) forwarding the digital signals (57) to the magnetic signal processing unit (250) by means of the input selector component (40).

13. A method as claimed in Claim 12 wherein the step (d) of acquiring data with regards to the magnetic signals (55) of Claim 8 further comprises the steps of:
i) after the preceding batch of the magnetic signals (55) has been digitalized into the digital signals (57), continuing to instruct the input selector components (40) by means of the magnetic signal digitalizing component (60) to select the next input channel (70) to receive the next batch of the magnetic signals (55) from the magnetic-field sensing components (30) by means of the input selector component (40);
ii) converting the magnetic signals (55) into the digital signals (57) by means of the input selector component (40); and
iii) forwarding the digital signals (57) to the magnetic signal processing unit (250) by means of the input selector component (40).

14. A method as claimed in any one of the Claims 12 to 13 wherein the step (d) of acquiring data with regards to the magnetic signals (55) of Claim 8 further comprises the steps of:
i) according to the instructions of the magnetic signal digitalizing component (60), continuing to select the next input channel (70) to receive the succeeding batch of the magnetic signals (55) into the digital signals (57) by means of the input selector components (40);
ii) converting the magnetic signals (55) to the digital signals (57) by means of the input selector components (40);
iii) forwarding the digital signals (57) to the magnetic signal processing unit (250) till the last batch of the magnetic signals (55) by means of the input selector components (40); and
iv) once the input selector components (40) reach the final batch of the magnetic signals (55), resetting the instructions to the first batch of another set of the magnetic signals (55) by means of the magnet signal digitalizing component (60).

15. A method as claimed in any one of the Claims 8 to 14 wherein the magnetic-field processing unit (250) comprises a magnetic-field processing component (90); the step (e) of processing and adapting the data in a displayable format of Claim 8 comprises the step of:
i) processing the digital signals (57) in batches, and
ii) appending the processed digital signals into a matrix format by means of the magnetic-field processing component (90),
wherein in particular the step (e) of processing and adapting the data in a displayable format of Claim 8 further comprises the step of:
i) repeating processing the batches of the digital signals (57); and
ii) appending the digital signals (57) into the matrix format till all of the digital signals (57) are processed by means of the magnetic-field processing component (90),
wherein in particular the step (e) of processing and adapting the data in a displayable format of Claim 8 further comprises the step of:
i) constructing a two-dimensional matrix format (59) by means of the magnetic-field processing component (90);
wherein the processed digital signals (57) are appended into a one-dimensional matrix format; and the digital signals (57) is continuously appended to the two-dimensional matrix format (59) as the magnetic-field processing component (90) continues to navigate through all the digital signals (57),
wherein in particular the digital signals (57) appended to the two-dimensional matrix format (59) in form of a two-dimensional array matrix (59) are used for imaging or visualization of a magnetic image of the ferromagnetic object (10).

## Patentansprüche

1. Ein System (100) zum Evaluieren ferromagnetischer Objekte (10), aufweisend:
eine Magnet-Abtastungseinheit (50), welche eine Mehrzahl von Magnetfeld-generierenden Komponenten (20) und eine Mehrzahl von Magnetfeld-abtastenden Komponenten (30) hat, welche so angeordnet sind, dass sie mit den Magnetfeld-generierenden Komponenten (20) operieren;
wobei die Magnetfeld-generierende Komponente (20) zum Magnetfeld Generieren ist;
wobei, während der Evaluation, das ferromagnetische Objekt (10) adaptiert ist, um sich unter Magnetfluss (210) relativ zu bewegen, welcher mittels jeder der Magnetfeld-generierenden Komponenten (20) generiert ist, und um sich über die Magnetfeld-abtastenden Komponenten (30) hinaus zu bewegen;
wobei die Magnetfeld-abtastende Komponente (30) zum Detektieren des Magnetflusses (210) ist, welcher als Magnetsignale (55) durch das ferromagnetische Objekt (10) fließt;
eine Magnetsignal-Erfassungseinheit (150) zum Erfassen von Daten unter Berücksichtigen der Magnetsignale (55) in Bezug zu dem Magnetfluss (210), welcher von dem ferromagnetischen Objekt (10) detektiert ist; und
eine Magnetsignal-Verarbeitungseinheit (250) zum Verarbeiten und Adaptieren der Daten in ein anzeigbares Format, wobei die Magnetfeld-abtastenden Komponenten (30) flankiert oder umgeben sind von den Magnetfeld-generierenden Komponenten (20), welche so angeordnet sind, dass der Magnetfluss (210), welcher mittels der Magnetfeld-generierenden Komponenten (20) generiert ist, an beiden Seiten von den Magnetfeld-abtastenden Komponenten (30) oder um die Magnetfeld-abtastenden Komponenten (30) herum in einer zueinander entgegengesetzten Richtung fließt; der Magnetfluss-Leckverlust, MFL, (220), welcher mittels der Magnetfeld-abtastenden Komponenten (30) detektiert ist, welcher in eine erste Richtung fließt, ein positives Magnetsignal (55) ergibt,
wohingegen der MFL (220), welcher mittels der Magnetfeld-abtastenden Komponenten (30) detektiert ist, welcher in eine zweite Richtung fließt, ein negatives Magnetsignal (55) ergibt;
die erste und die zweite Richtung in der entgegengesetzten Richtung zueinander sind;
und die Magnetfeld-abtastenden Komponenten (30) den MFL (220) in Größeneinheiten von einem Magnetfeld-Leckverlust Dichtewert messen.

2. Ein System (100) gemäß Anspruch 1, wobei das System (100) so eingerichtet ist, dass
ohne die Anwesenheit von dem ferromagnetischen Objekt (10) in dem System (100), der Magnetfluss (210), welcher mittels der Magnetfeld-generierenden Komponenten (20) generiert ist, nicht in einem Muster fließt, welches mittels der Magnetfeld-abtastenden Komponenten (30) detektierbar ist;
in der Anwesenheit von dem ferromagnetischen Objekt (10) in der Nähe von den Magnetfeld-generierenden Komponenten (20) der Magnetfluss (210) durch das ferromagnetische Objekt (10) fließt und der Magnetfluß-Leckverlust, MFL, (220) generiert ist;
und der MFL (220) in einem Muster fließt, welches mittels der Magnetfeld-abtastenden Komponenten (30) detektierbar ist,
wobei insbesondere
die Magnetfeld-abtastenden Komponenten (30) den detektierten MFL (220) in die Magnetsignale (55) in Form von Spannungssignalen V_{H} an der Ausgabe davon umwandelt.

3. Ein System (100) gemäß einem beliebigen von den Ansprüchen 1 bis 2, wobei die erste Richtung und die zweite Richtung von dem MFL (220), welcher mittels der Magnetfeld-abtastenden Komponenten (30) detektiert ist, eine Aufwärts- bzw. eine Abwärtsrichtung ist.

4. Ein System (100) gemäß einem beliebigen von den Ansprüchen 1 bis 3, wobei das System (100) so eingerichtet ist, dass
wenn das ferromagnetische Objekt (10) in der Nähe von der Magnetfeld-generierenden Komponente (20) ist, je näher das ferromagnetische Objekt (10) an die Magnetfeld-abtastenden Komponenten (30) kommt, desto relativ höher ist der MFL Dichtewert, wohingegen je mehr sich das ferromagnetische Objekt (10) von Magnetfeld-abtastenden Komponenten (30) entfernt, desto relativ niedriger ist der MFL Dichtewert, und/oder
wobei das System (100) so eingerichtet ist, dass die Magnetfeld-generierenden Komponenten (20) an beiden Seiten von den Magnetfeld-abtastenden Komponenten oder um die Magnetfeld-abtastenden Komponenten (30) herum dieselbe Dichte von dem Magnetfluss (210) generieren und so eingerichtet sind, dass wenn
das ferromagnetische Objekt (10) sich zu dem Zentrum von den Magnetfeld-abtastenden Komponenten (30) bewegt, beide MFL (220) von beiden Seiten von den Magnetfeld-abtastenden Komponenten (30) oder der MFL (220) um die Magnetfeld-abtastenden Komponenten (30) herum mittels der Magnetfeld-abtastenden Komponenten (30) detektiert sind, und/oder
wobei das System (100) so eingerichtet ist, dass wenn das ferromagnetische Objekt (10) sich zu dem Zentrum von der Magnetfeld-abtastenden Komponente (30) bewegt, wegen derselben Dichte von dem Magnetfluss (210), welcher in die entgegengesetzten Richtungen von beiden Seiten von den Magnetfeld-abtastenden Komponenten (30) oder um die Magnetfeld-abtastenden Komponenten (30) herum fließt, sind die MFL (220) von beiden Seiten von den Magnetfeld-abtastenden Komponenten (30) oder um die Magnetfeld-abtastenden Komponenten (30) herum von derselben Dichte, und die MFL (220), von den beiden Seiten oder darum herum, löschen sich gegenseitig aus, wobei sich keine Magnetsignale (55) für die Magnetfeld-abtastenden Komponenten (30) ergeben, d.h. kein MFL Dichtewert.

5. Ein System (100) gemäß einem beliebigen von den Ansprüchen 1 bis 4, wobei das System (100) so eingerichtet ist, dass
die Magnetsignal-Erfassungseinheit (150) aufweist
eine Mehrzahl von Eingabe-Selektor-Komponenten (40), und eine Magnetsignaldigitalisierende Komponente (60);
die Eingabe-Selektor-Komponente (40) aufweist
eine Mehrzahl von Eingabekanälen (70) und einen Ausgang (80);
die Eingabe-Selektor-Komponente (40) zum Empfangen des Magnetsignals (55) von den Magnetfeld-abtastenden Komponenten (30) ist;
die Magnetfeld-digitalisierende Komponente (60) zum Instruieren der Eingabe-Selektor Komponenten (40) ist, um einen von den Eingabekanälen (70) auszuwählen, um eine Anzahl von den Magnetsignalen (55) selektiv in Batches von den Magnetfeld-abtastenden Komponenten (30) zu empfangen, zum Umwandeln der Magnetsignale (55) in Digitalsignale (57), und zum Weiterleiten der Digitalsignale (57) an die Magnetsignal-Verarbeitungseinheit (250),
wobei, insbesondere nachdem das vorangehende Batch von den Magnetsignalen (55) in die Digitalsignale (57) digitalisiert wurde, die Magnetsignal-digitalisierende Komponente (60) ferner zum Fortfahren eines Instruierens der Eingabe-Selektor Komponenten (40) ist, um den nächsten Eingabe Kanal (70) auszuwählen, um das nächste Batch von den Magnetsignalen (55) von den Magnetfeld-abtastenden Komponenten (30) zu empfangen, zum Umwandeln der Magnetsignale (55) in die Digitalsignale (57) und zum Weiterleiten der Digitalsignale (57) an die Magnetsignal-Verarbeitungseinheit (250).

6. Ein System (100) gemäß Anspruch 5, wobei das System (100) so angeordnet ist, dass gemäß den Instruktionen von der Magnetsignal-digitalisierenden Komponente (60), die Eingabe-Selektor Komponenten (40) fortfahren mit
Auswählen des nächsten Eingabekanals (70), um das nachfolgende Batch von den Magnetsignalen (55) zu empfangen;
Umwandeln der Magnetsignale (55) in die Digitalsignale (57), und Weiterleiten der Digitalsignale (57) an die Magnetsignal-Verarbeitungseinheit (250) bis zum letzten Batch von den Magnetsignalen (55);
und sobald die Eingabe-Selektor Komponenten (40) das finale Batch von den Magnetsignalen (55) erreichen, Zurücksetzen der Instruktionen der Magnetfelddigitalisierenden Komponenten (60) auf das erste Batch von einem anderen Satz von den Magnetsignalen (55).

7. Ein System (100) gemäß einem beliebigen von den Ansprüchen 1 bis 5, wobei das System (100) so eingerichtet ist, dass die Magnetsignal-Verarbeitungseinheit (250) eine Magnetfeld-verarbeitende Komponente (90) aufweist;
wobei die Magnetfeld-verarbeitende Komponente (90) zum Verarbeiten der Digitalsignale (57) in Batches ist, und zum Anhängen der verarbeiteten Digitalsignale in ein Matrixformat,
wobei insbesondere die Magnetfeld-verarbeiteten Komponente (90) ferner zum Wiederholen von dem Verarbeiten der Batches von den Digitalsignalen (57) ist und zum Anhängen der Digitalsignale (57) in das Matrixformat bis alle von den Digitalsignalen (57) verarbeitet sind,
wobei insbesondere die verarbeiteten Digitalsignale (57) angehängt sind in ein ein-dimensionales Matrixformat;
wobei die Magnetfeld-verarbeitende Komponente (90) ferner zum Konstruieren eines zwei-dimensionalen Matrixformats (59) ist; und die Digitalsignale (57) kontinuierlich an das zwei-dimensionale Matrixformat (59) angehängt werden, wenn die Magnetfeld-verarbeitende Komponente (90) fortfährt durch alle die Digitalsignale (57) zu navigieren,
wobei insbesondere die Digitalsignale (57), welche an das zwei-dimensionale Matrixformat (59) in einer zwei-dimensionalen Array-Matrix angehängt sind, verwendet werden zum Abbilden oder Visualisieren von einer Magnetabbildung von dem ferromagnetischen Objekt (10).

8. Ein Verfahren zum Evaluieren ferromagnetischer Objekte (10), aufweisend die Schritte:
a) Generieren von Magnetfeldern mittels von einer Mehrzahl von Magnetfeld-generierenden Komponenten (20), wobei eine Mehrzahl von Magnetfeld-abtastenden Komponenten (30) adaptiert sind, mit den Magnetfeld-generierenden Komponenten (20) zu operieren;
b) Erlauben der ferromagnetischen Objekte sich relativ unter Magnetfluss (210) zu bewegen, welcher mittels jeder von den Magnetfeld-generierenden Komponenten (20) generiert wurde, und sich über die Magnetfeld-abtastenden Komponenten (30) hinaus zu bewegen;
c) Detektieren des Magnetflusses (210), welcher durch das ferromagnetische Objekt (10) fließt, als Magnetsignale (55) mittels Magnetfeldabtastender Komponenten, wobei der Magnetfluss an beiden Seiten von den Magnetfeld-abtastenden Komponenten (30) oder um die Magnetfeld-abtastenden Komponenten (30) herum in einer entgegengesetzten Richtung zueinander fließt;
d) Erfassen von Daten unter Berücksichtigung der Magnetsignale (55) in Bezug zu dem Magnetfluss (210), welcher von dem ferromagnetischen Objekt (10) mittels einer Magnetsignal-Erfassungseinheit (150) detektiert wurde; und
e) Verarbeiten und Adaptieren der Daten in ein anzeigbares Format mittels einer Magnetsignal-Verarbeitungseinheit (250).

9. Ein Verfahren gemäß Anspruch 8, wobei
ohne die Anwesenheit von dem ferromagnetischen Objekt (10), der Magnetfluss (210), welcher mittels der Magnetfeld-generierenden Komponenten (20) generiert wurde, nicht in einem Muster fließt, welches mittels der Magnetfeld-abtastenden Komponenten (30) detektierbar ist;
in der Anwesenheit von dem ferromagnetischen Objekt (10) in der Nähe von den Magnetfeld-generierenden Komponenten (20) der Magnetfluss (210) durch das ferromagnetische Objekt (10) fließt und der Magnetfluss Leckverlust, MFL (220), generiert wird,
und der MFL (220) in einem Muster fließt, welches mittels der Magnetfeld-abtastenden Komponenten (30) detektierbar ist,
wobei insbesondere
die Magnetfeld-abtastenden Komponenten (30) die detektierten MFL (220) in die Magnetsignale (55) in Form von Spannungssignalen V_{H} an dem Ausgang davon umwandeln.

10. Ein Verfahren gemäß einem beliebigen von den Ansprüchen 8 bis 9, wobei die Magnetfeld-abtastenden Komponenten (30) flankiert oder umgeben sind von den Magnetfeld-generierenden Komponenten (20);
der Magnetfluss (210), welcher mittels der Magnetfeld-generierenden Komponenten (20) generiert wurde, auf beiden Seiten von den Magnetfeldabtastenden Komponenten (30) oder um die Magnetfeld-abtastenden Komponenten (30) herum in entgegengesetzter Richtung zueinander fließt;
der MFL (220), welcher mittels der Magnetfeld-abtastenden Komponenten (30) detektiert wurde, welcher in eine erste Richtung fließt, ein positives Magnetsignal (55) ergibt, wohingegen
der MFL (220), welcher mittels der Magnetfeld-abtastenden Komponenten (30) detektiert wurde, welcher in eine zweite Richtung fließt, ein negatives Magnetsignal (55) ergibt;
die erste und die zweite Richtung zueinander in entgegengesetzter Richtung sind; und die Magnetfeld-abtastenden Komponenten (30) den MFL (220) in Größeneinheiten von einem Magnetfeld-Leckverlust Dichtewert messen, wobei insbesondere die erste und die zweite Richtung von dem MFL (220), welcher mittels der Magnetfeld-abtastenden Komponenten (30) detektiert wurde, eine Aufwärts- bzw. eine Abwärtsrichtung ist.

11. Ein Verfahren gemäß einem beliebigen von den Ansprüchen 8 bis 10, wobei,
wenn das ferromagnetische Objekt (10) in der Nähe von den Magnetfeld-generierenden Komponenten (20) ist,
je näher das ferromagnetische Objekt (10) zu den Magnetfeld-abtastenden Komponenten (30) kommt, desto relativ höher ist der MFL Dichtewert, wohingegen je mehr sich das ferromagnetische Objekt (10) von den Magnetfeld-abtastenden Komponenten (30) entfernt, desto relativ geringer ist der MFL Dichtewert, und/oder
wobei die Magnetfeld-generierenden Komponenten (20) an beiden Seiten von den Magnetfeld-abtastenden Komponenten (30) oder um die Magnetfeld-abtastenden Komponenten (30) herum, dieselbe Dichte von dem Magnetfluss (210) generieren;
wenn das ferromagnetische Objekt (10) sich zu dem Zentrum von den Magnetfeld-abtastenden Komponenten (30) bewegt, werden beide MFL (220) von beiden Seiten von den Magnetfeld-abtastenden Komponenten (30) oder der MFL (220) um die Magnetfeld-abtastenden Komponenten (30) herum mittels der Magnetfeld-abtastenden Komponenten (30) detektiert, und/oder wobei, wenn das ferromagnetische Objekt (10) sich zu dem Zentrum von der Magnetfeld-abtastenden Komponente (30) bewegt, wegen derselben Dichte von dem Magnetfluss (210), welcher in die entgegengesetzten Richtungen von beiden Seiten von den Magnetfeld-abtastenden Komponenten (30) oder um die Magnetfeld-abtastenden Komponenten (30) herum,
sind die MFL (220) von beiden Seiten von den Magnetfeld-abtastenden Komponenten (30) oder um die Magnetfeld-abtastenden Komponenten (30) herum von derselben Dichte, und die MFL (220) von den beiden Seiten oder darum herum löschen sich gegenseitig aus, wobei sich keine Magnetsignale (55) für die Magnetfeld-abtastenden Komponenten (30) ergeben, d.h. kein MFL Dichtewert.

12. Ein Verfahren gemäß einem beliebigen von den Ansprüchen 8 bis 11, wobei die Magnetsignal-Erfassungseinheit (150) aufweist
eine Mehrzahl von Eingabe-Selektor Komponenten (40), und eine Magnetsignal-digitalisierende Komponente (60);
die Eingabe-Selektor Komponente (40) aufweist
eine Mehrzahl von Eingabekanälen (70) und einen Ausgang (80);
der Schritt (d) des Erfassens von Daten unter Berücksichtigung der Magnetsignale (55), gemäß Anspruch 8, die Schritte aufweist:
i) Empfangen des Magnetsignals (55) von den Magnetfeld-abtastenden Komponenten (30) mittels der Eingabe-Selektor Komponente (40);
ii) Instruieren der Eingabe-Selektor Komponenten mittels der Magnetsignal-digitalisierenden Komponente (60), um einen von den Eingabekanälen (70) auszuwählen, um eine Anzahl von den Magnetsignalen (55) selektiv in Batches von den Magnetfeld-abtastenden Komponenten (30) zu empfangen mittels der Eingabe-Selektor Komponente (40);
iii) Umwandeln der Magnetsignale (55) in Digitalsignale (57) mittels der Eingabe-Selektor Komponente (40); und
iv) Weiterleiten der Digitalsignale (57) an die Magnetsignal-Verarbeitungseinheit (250) mittels der Eingabe-Selektor Komponente (40).

13. Ein Verfahren gemäß Anspruch 12, wobei der Schritt d) des Daten Erfassens in Bezug auf die Magnetsignale (55), gemäß Anspruch 8, ferner die Schritte aufweist:
i) nachdem das vorangehende Batch von den Magnetsignalen (55) in die Digitalsignale (57) digitalisiert wurde,
Fortsetzen des Instruierens der Eingabe-Selektor Komponenten (40) mittels der Magnetsignal-digitalisierenden Komponente (60), um den nächsten Eingabekanal (70) auszuwählen, um das nächste Batch von den Magnetsignalen (55) von den Magnetfeld-abtastenden Komponenten (30) zu empfangen mittels der Eingabe-Selektor Komponente (40);
ii) Umwandeln der Magnetsignale (55) in die Digitalsignale (57) mittels der Eingabe-Selektor Komponente (40); und
iii) Weiterleiten der Digitalsignale (57) an die Magnetsignal-Verarbeitungseinheit (250) mittels der Eingabe-Selektor Komponente (40).

14. Ein Verfahren gemäß einem beliebigen von den Ansprüchen 12 bis 13, wobei der Schritt (d) des Daten-Erfassens unter Berücksichtigung der Magnetsignale (55), gemäß Anspruch 8, ferner die Schritte aufweist:
i) Gemäß den Instruktionen von der Magnetsignal-digitalisierenden Komponente (60), Fortfahren des Auswählens des nächsten Eingabekanals (70), um das folgende Batch von den Magnetsignalen (55) in den Digitalsignalen (57) mittels den Eingabe-Selektor Komponenten (40) zu empfangen;
ii) Umwandeln der Magnetsignale (55) in die Digitalsignale (57) mittels den Eingabe-Selektor Komponenten (40);
iii) Weiterleiten der Digitalsignale (57) an die Magnetsignal-Verarbeitungseinheit (250) bis zu dem letzten Batch von den Magnetsignalen (55) mittels den Eingabe-Selektor Komonenten (40); und
iv) sobald die Eingabe-Selektor Komponenten (40) das finale Batch von den Magnetsignalen (55) erreichen, Zurücksetzen der Instruktionen auf das erste Batch von einem anderen Satz von den Magnetsignalen (55) mittels der Magnetsignal-digitalisierenden Komponente (60).

15. Ein Verfahren gemäß einem beliebigen von den Ansprüchen 8 bis 14, wobei die Magnetfeld-Verarbeitungseinheit (250) aufweist
eine Magnetfeld-verarbeitende Komponente (90);
der Schritt (e) des Verarbeitens und Adaptierens der Daten in einem anzeigbaren Format, gemäß Anspruch 8, die Schritte aufweist:
i) Verarbeiten der Digitalsignale (57) in Batches, und
ii) Anhängen der verarbeiteten Digitalsignale in ein Matrixformat mittels der Magnetfeld-verarbeitenden Komponente (90),
wobei insbesondere der Schritt (e) des Prozessierens und Adaptierens der Daten in ein anzeigbares Format, gemäß Anspruch 8, ferner die Schritte aufweist:
i) Wiederholen des Verarbeitens der Batches von den Digitalsignalen (57); und
ii) Anhängen der Digitalsignale (57) in das Matrixformat bis alle von den Digitalsignalen (57) verarbeitet sind mittels der Magnetfeld-verarbeitenden Komponente (90),
wobei insbesondere der Schritt (e) des Verarbeitens und Adaptierens der Daten in ein anzeigbares Format, gemäß Anspruch 8, ferner die Schritte aufweist:
i) Konstruieren eines zwei-dimensionalen Matrixformats (59) mittels der Magnetfeld-verarbeitenden Komponente (90);
wobei die verarbeiteten Digitalsignale (57) in ein ein-dimensionales Matrixformat angehängt sind;
und die Digitalsignale (57) kontinuierlich an das zwei-dimensionale Matrixformat (59) angehängt werden, sowie die Magnetfeld-verarbeitende Komponente (90) fortfährt durch alle die Digitalsignale (57) zu navigieren,
wobei insbesondere die Digitalsignale (57), welche an das zwei-dimensionale Matrixformat (59) in Form von einer zwei-dimensionalen Array-Matrix (59) angehängt sind, verwendet werden zum Abbilden oder Visualisieren von einer Magnetabbildung von dem ferromagnetischen Objekt (10).

## Revendications

1. Système (100) pour évaluer des objets ferromagnétiques (10) comprenant :
une unité de détection magnétique (50) comportant une pluralité de composants de génération de champ magnétique (20), et une pluralité de composants de détection de champ magnétique (30) agencés de manière à fonctionner avec les composants de génération de champ magnétique (20) ; dans lequel le composant de génération de champ magnétique (20) est destiné à générer un champ magnétique ; au cours de l'évaluation, l'objet ferromagnétique (10) est apte à effectuer un déplacement relatif sous l'effet d'un flux magnétique (210) généré par chacun des composants de génération de champ magnétique (20) et à passer par les composants de détection de champ magnétique (30) ; le composant de détection de champ magnétique (30) est destiné à détecter le flux magnétique (210) qui traverse l'objet ferromagnétique (10) en tant que signaux magnétiques (55) ;
une unité d'acquisition de signal magnétique (150) destinée à acquérir des données relatives aux signaux magnétiques (55) en relation avec le flux magnétique (210) détecté à partir de l'objet ferromagnétique (10) ; et
une unité de traitement de signal magnétique (250) pour traiter et adapter les données dans un format affichable,
dans lequel les composants de détection de champ magnétique (30) sont flanqués ou entourés de composants de génération de champ magnétique (20) qui sont agencés de sorte que les flux magnétiques (210) générés par les composants de génération de champ magnétique (20) de chaque côté ou autour des composants de détection de champ magnétique (30) s'écoulent dans un sens opposé l'un à l'autre ; la fuite de flux magnétique, MFL, (220) détectée par les composants de détection de champ magnétique (30) s'écoulant dans un premier sens donne un signal magnétique positif (55), tandis que la MFL (220) détectée par les composants de détection de champ magnétique (30) s'écoulant dans un deuxième sens donne un signal magnétique négatif (55) ; le premier sens est opposé au deuxième sens ; et les composants de détection de champ magnétique (30) mesurent la MFL (220) en termes de valeur de densité de fuite de champ magnétique.

2. Système (100) selon la revendication 1, dans lequel le système (100) est agencé de sorte que, sans la présence de l'objet ferromagnétique (10) dans le système (100), le flux magnétique (210) généré par les composants de génération de champ magnétique (20) ne s'écoule pas dans un motif détectable par les composants de détection de champ magnétique (30) ; en présence de l'objet ferromagnétique (10) à proximité des composants de génération de champ magnétique (20), le flux magnétique (210) traverse l'objet ferromagnétique (10) et la fuite de flux magnétique, MFL, (220) est générée ; et la MFL (220) s'écoule dans un motif détectable par les composants de détection de champ magnétique (30), dans lequel en particulier les composants de détection de champ magnétique (30) convertissent la MFL détectée (220) en signaux magnétiques (55) sous forme de signaux de tension V_{H} à la sortie de ceux-ci.

3. Système (100) selon l'une quelconque des revendications 1 et 2, dans lequel le premier sens et le deuxième sens de la MFL (220) détectée par les composants de détection de champ magnétique (30) sont respectivement vers le haut et vers le bas.

4. Système (100) selon l'une quelconque des revendications 1 à 3, dans lequel le système (100) est agencé de sorte que, lorsque l'objet ferromagnétique (10) se trouve à proximité du composant de génération de champ magnétique (20), les valeurs de densité de MFL augmentent lorsque l'objet ferromagnétique (10) se rapproche des composants de détection de champ magnétique (30), tandis que les valeurs de densité de MFL diminuent lorsque l'objet ferromagnétique (10) s'éloigne des composants de détection de champ magnétique (30), et/ou
dans lequel le système (100) est agencé de sorte que les composants de génération de champ magnétique (20) de chaque côté ou autour des composants de détection de champ magnétique (30) génèrent la même densité du flux magnétique (210) et est agencé de sorte que, lorsque l'objet ferromagnétique (10) se déplace vers le centre des composants de détection de champ magnétique (30), la MFL (220) de chaque côté ou la MFL (220) autour des composants de détection de champ magnétique (30) est détectée par les composants de détection de champ magnétique (30), et/ou
dans lequel le système (100) est agencé de sorte que, lorsque l'objet ferromagnétique (10) se déplace vers le centre du composant de détection de champ magnétique (30), en raison de la même densité du champ magnétique (210) s'écoulant dans les sens opposés des deux côtés ou autour des composants de détection de champ magnétique (30), les MFL (220) des deux côtés ou autour des composants de détection de champ magnétique (30) ont la même densité et les MFL (220) des deux côtés ou autour de ceux-ci s'annulent en donnant aucun signal magnétique (55) pour les composants de détection de champ magnétique (30), c'est-à-dire aucune valeur de densité de MFL.

5. Système (100) selon l'une quelconque des revendications 1 à 4, dans lequel le système (100) est agencé de sorte que l'unité d'acquisition de signal magnétique (150) comprend une pluralité de composants de sélection d'entrée (40), et un composant de numérisation de signal magnétique (60) ; le composant de sélection d'entrée (40) comprend une pluralité de canaux d'entrée (70) et une sortie (80) ; le composant de sélection d'entrée (40) est destiné à recevoir le signal magnétique (55) provenant des composants de détection de champ magnétique (30) ; le composant de numérisation de signal magnétique (60) est destiné à ordonner aux composants de sélection d'entrée (40) de sélectionner l'un des canaux d'entrée (70) pour recevoir un nombre de signaux magnétiques (55) sélectivement en lots à partir des composants de détection de champ magnétique (30), à convertir les signaux magnétiques (55) en signaux numériques (57), et à transférer les signaux numériques (57) à l'unité de traitement de signal magnétique (250),
dans lequel en particulier après que le lot précédent de signaux magnétiques (55) a été numérisé en signaux numériques (57), le composant de numérisation de signal magnétique (60) est en outre destiné à continuer à ordonner aux composants de sélection d'entrée (40) de sélectionner le canal d'entrée suivant (70) pour recevoir le lot suivant de signaux magnétiques (55) à partir des composants de détection de champ magnétique (30), à convertir les signaux magnétiques (55) en signaux numériques (57), et à transférer les signaux numériques (57) à l'unité de traitement de signal magnétique (250).

6. Système (100) selon la revendication 5, dans lequel le système (100) est agencé de sorte que, selon les instructions du composant de numérisation de signal magnétique (60), les composants de sélection d'entrée (40) continuent de sélectionner le canal d'entrée suivant (70) pour recevoir le lot suivant de signaux magnétiques (55); de convertir les signaux magnétiques (55) en signaux numériques (57), et de transférer les signaux numériques (57) à l'unité de traitement de signal magnétique (250) jusqu'au dernier lot de signaux magnétiques (55) ; et une fois que les composants de sélection d'entrée (40) ont atteint le dernier lot de signaux magnétiques (55), le composant de numérisation de signal magnétique (60) réinitialise son instruction au premier lot d'un autre ensemble de signaux magnétiques (55).

7. Système (100) selon l'une quelconque des revendications 1 à 5, dans lequel le système (100) est agencé de sorte que l'unité de traitement de signal magnétique (250) comprenne un composant de traitement de champ magnétique (90) ; le composant de traitement de champ magnétique (90) est destiné à traiter les signaux numériques (57) en lots, et à annexer les signaux numériques traités dans un format de matrice,
dans lequel en particulier le composant de traitement de champ magnétique (90) est en outre destiné à répéter le traitement des lots de signaux numériques (57) et à annexer les signaux numériques (57) dans le format de matrice jusqu'à ce que tous les signaux numériques (57) soient traités,
dans lequel en particulier les signaux numériques traités (57) sont annexés dans un format de matrice unidimensionnelle ; le composant de traitement de champ magnétique (90) est en outre destiné à construire un format de matrice bidimensionnelle (59) ; et les signaux numériques (57) sont continuellement annexés au format de matrice bidimensionnelle (59) pendant que le composant de traitement de champ magnétique (90) continue de parcourir tous les signaux numériques (57),
dans lequel en particulier les signaux numériques (57) annexés au format de matrice bidimensionnelle (59) dans une matrice de réseau bidimensionnelle (59) sont utilisés pour l'imagerie ou la visualisation d'une image magnétique de l'objet ferromagnétique (10).

8. Procédé pour évaluer des objets ferromagnétiques (10) comprenant les étapes de :
a) générer un champ magnétique au moyen d'une pluralité de composants de génération de champ magnétique (20), dans lequel une pluralité de composants de détection de champ magnétique (30) sont aptes à fonctionner avec les composants de génération de champ magnétique (20) ;
b) permettre aux objets ferromagnétiques d'effectuer un déplacement relatif sous l'effet d'un flux magnétique (210) généré par chacun des composants de génération de champ magnétique (20) et de passer par les composants de détection de champ magnétique (30) ;
c) détecter le flux magnétique (210) qui traverse l'objet ferromagnétique (10) en tant que signaux magnétiques (55) au moyen de composants de détection de champ magnétique, dans lequel les flux magnétiques de chaque côté ou autour des composants de détection de champ magnétique (30) s'écoulent dans des sens opposés l'un à l'autre ;
d) acquérir des données relatives aux signaux magnétiques (55) en relation avec le flux magnétique (210) détecté à partir de l'objet ferromagnétique (10) au moyen d'une unité d'acquisition de signal magnétique (150) ; et
e) traiter et adapter les données dans un format affichable au moyen d'une unité de traitement de signal magnétique (250).

9. Procédé selon la revendication 8, dans lequel, sans la présence de l'objet ferromagnétique (10), le flux magnétique (210) généré par les composants de génération de champ magnétique (20) ne s'écoule pas dans un motif détectable par les composants de détection de champ magnétique (30) ; en présence de l'objet ferromagnétique (10) à proximité des composants de génération de champ magnétique (20), le flux magnétique (210) traverse l'objet ferromagnétique (10) et la fuite de flux magnétique, MFL, (220) est générée ; et la MFL (220) s'écoule dans un motif détectable par les composants de détection de champ magnétique (30), dans lequel en particulier les composants de détection de champ magnétique (30) convertissent la MFL détectée (220) en signaux magnétiques (55) sous forme de signaux de tension V_{H} à la sortie de ceux-ci.

10. Procédé selon l'une quelconque des revendications 8 et 9, dans lequel les composants de détection de champ magnétique (30) sont flanqués ou entourés des composants de génération de champ magnétique (20) ; les flux magnétiques (210) générés par les composants de génération de champ magnétique (20) de chaque côté ou autour des composants de détection de champ magnétique (30) s'écoulent dans un sens opposé l'un à l'autre ; la MFL (220) détectée par les composants de détection de champ magnétique (30) s'écoulant dans un premier sens donne un signal magnétique positif (55), tandis que la MFL (220) détectée par les composants de détection de champ magnétique (30) s'écoulant dans un deuxième sens donne un signal magnétique négatif (55) ; le premier sens est opposé au deuxième sens ; et les composants de détection de champ magnétique (30) mesurent la MFL (220) en termes de valeur de densité de fuite de champ magnétique, dans lequel en particulier le premier sens et le deuxième sens de la MFL (220) détectée par les composants de détection de champ magnétique (30) sont respectivement vers le haut et vers le bas.

11. Procédé selon l'une quelconque des revendications 8 à 10, dans lequel lorsque l'objet ferromagnétique (10) se trouve à proximité du composant de génération de champ magnétique (20), les valeurs de densité de MFL augmentent lorsque l'objet ferromagnétique (10) se rapproche des composants de détection de champ magnétique (30), tandis que les valeurs de densité de MFL diminuent lorsque l'objet ferromagnétique (10) s'éloigne des composants de détection de champ magnétique (30), et/ou
dans lequel les composants de génération de champ magnétique (20) de chaque côté ou autour des composants de détection de champ magnétique (30) génèrent la même densité du flux magnétique (210) ; lorsque l'objet ferromagnétique (10) se déplace vers le centre des composants de détection de champ magnétique (30), la MFL (220) de chaque côté ou la MFL (220) autour des composants de détection de champ magnétique (30) est détectée par les composants de détection de champ magnétique (30), et/ou
dans lequel, lorsque l'objet ferromagnétique (10) se déplace vers le centre du composant de détection de champ magnétique (30), en raison de la même densité du champ magnétique (210) s'écoulant dans les sens opposés des deux côtés ou autour des composants de détection de champ magnétique (30), les MFL (220) des deux côtés ou autour des composants de détection de champ magnétique (30) ont la même densité et les MFL (220) des deux côtés ou autour de ceux-ci s'annulent en donnant aucun signal magnétique (55) pour les composants de détection de champ magnétique (30), c'est-à-dire aucune valeur de densité de MFL.

12. Procédé selon l'une quelconque des revendications 8 à 11, dans lequel l'unité d'acquisition de signal magnétique (150) comprend une pluralité de composants de sélection d'entrée (40), et un composant de numérisation de signal magnétique (60) ; le composant de sélection d'entrée (40) comprend une pluralité de canaux d'entrée (70) et une sortie (80) ; l'étape (d) consistant à acquérir des données relatives aux signaux magnétiques (55) de la revendication 8 comprend les étapes de :
i) recevoir le signal magnétique (55) provenant des composants de détection de champ magnétique (30) au moyen du composant de sélection d'entrée (40) ;
ii) ordonner aux composants de sélection d'entrée (40), au moyen du composant de numérisation de signal magnétique (60), de sélectionner l'un des canaux d'entrée (70) pour recevoir un nombre de signaux magnétiques (55) sélectivement en lots à partir des composants de détection de champ magnétique (30) au moyen du composant de sélection d'entrée (40) ;
iii) convertir les signaux magnétiques (55) en signaux numériques (57) au moyen du composant de sélection d'entrée (40) ; et
iv) transférer les signaux numériques (57) à l'unité de traitement de signal magnétique (250) au moyen du composant de sélection d'entrée (40).

13. Procédé selon la revendication 12, dans lequel l'étape (d) consistant à acquérir des données relatives aux signaux magnétiques (55) de la revendication 8 comprend en outre les étapes de :
i) après que le lot précédent de signaux magnétiques (55) a été numérisé en signaux numériques (57), continuer à ordonner aux composants de sélection d'entrée (40), au moyen du composant de numérisation de signal magnétique (60), de sélectionner le canal d'entrée suivant (70) pour recevoir le lot suivant de signaux magnétiques (55) à partir des composants de détection de champ magnétique (30) au moyen du composant de sélection d'entrée (40) ;
ii) convertir les signaux magnétiques (55) en signaux numériques (57) au moyen du composant de sélection d'entrée (40) ; et
iii) transférer les signaux numériques (57) à l'unité de traitement de signal magnétique (250) au moyen du composant de sélection d'entrée (40).

14. Procédé selon l'une quelconque des revendications 12 et 13, dans lequel l'étape (d) consistant à acquérir des données relatives aux signaux magnétiques (55) de la revendication 8 comprend en outre les étapes de :
i) selon les instructions du composant de numérisation de signal magnétique (60), continuer de sélectionner le canal d'entrée suivant (70) pour recevoir le lot suivant des signaux magnétiques (55) en signaux numériques (57) au moyen des composants de sélection d'entrée (40) ;
ii) convertir les signaux magnétiques (55) en signaux numériques (57) au moyen des composants de sélection d'entrée (40) ;
iii) transférer les signaux numériques (57) à l'unité de traitement de signal magnétique (250) jusqu'au dernier lot de signaux magnétiques (55) au moyen des composants de sélection d'entrée (40) ; et
iv) une fois que les composants de sélection d'entrée (40) ont atteint le dernier lot de signaux magnétiques (55), réinitialiser les instructions au premier lot d'un autre ensemble de signaux magnétiques (55) au moyen du composant de numérisation de signal magnétique (60).

15. Procédé selon l'une quelconque des revendications 8 à 14, dans lequel l'unité de traitement de champ magnétique (250) comprend un composant de traitement de champ magnétique (90) ; l'étape (e) consistant à traiter et à adapter les données dans un format affichable de la revendication 8 comprend les étapes de :
i) traiter les signaux numériques (57) en lots, et
ii) annexer les signaux numériques traités dans un format de matrice au moyen du composant de traitement de champ magnétique (90),
dans lequel en particulier l'étape (e) consistant à traiter et à adapter les données dans un format affichable de la revendication 8 comprend en outre les étapes de :
i) répéter le traitement des lots de signaux numériques (57) ; et
ii) annexer les signaux numériques (57) dans le format de matrice jusqu'à ce que tous les signaux numériques (57) soient traités au moyen du composant de traitement de champ magnétique (90),
dans lequel en particulier l'étape (e) consistant à traiter et à adapter les données dans un format affichable de la revendication 8 comprend en outre l'étape de :
i) construire un format de matrice bidimensionnelle (59) au moyen du composant de traitement de champ magnétique (90) ;
dans lequel les signaux numériques traités (57) sont annexés dans un format de matrice unidimensionnelle ; et les signaux numériques (57) sont continuellement annexés au format de matrice bidimensionnelle (59) pendant que le composant de traitement de champ magnétique (90) continue de parcourir tous les signaux numériques (57),
dans lequel en particulier les signaux numériques (57) annexés au format de matrice bidimensionnelle (59) sous forme d'une matrice de réseau bidimensionnelle (59) sont utilisés pour l'imagerie ou la visualisation d'une image magnétique de l'objet ferromagnétique (10).
